# EUROPEAN PATENT APPLICATION

(11) **EP 1 657 746 A1**
(43) Date of publication of application: **17.05.2006**
(21) Application number: 04771767.3
(22) Date of filing: 11.08.2004
(51) Int. Cl.: H01L 23/12, H01L 25/04, H01L 23/52, H01L 27/04

(54) **SEMICONDUCTOR DEVICE AND METHOD FOR MAKING THE SAME**

(30) Priority: 19.08.2003 JP 2003294936
(71) Applicant: SONY CORPORATION, Tokyo 141-0001 (JP)
(72) Inventor: IWABUCHI, Shin, (JP)
(74) Representative: Thévenet, Jean-Bruno
(86) International application number: PCT/JP2004/011806
(87) International publication number: WO 2005/017999

(57) **Abstract**

An MCM-type semiconductor device allowing high-speed operation and reduction in power consumption, and is also capable of preventing reliability and yield rate of MCM from degrading. The reduction in power consumption and increase in operation speed are attained by connecting signal lines between in-chip circuits (30), (32) in an electrically direct manner. On the signal line, a protection circuit (406) for electrostatic damage protection is provided. In device fabrication, connection using interconnections (12) between the in-chip circuits (30), (32) is carried out while keeping a protection circuit (406) connected to the signal lines (internal draw-out lines (12a), internal interconnections (14)), by which circuit components can be protected from static electricity even if electric charge accumulated on the semiconductor chips (20), (22) should flow into the signal lines, because the protection circuit (406) can absorb the charge. After the connection is completed, the protection circuit (406) can be disconnected from the signal lines, so as to avoid the protection circuit (406) to function as a load on the in-chip circuits (30), (32) during normal operation, and to thereby prevent the operation speed from decreasing.

## Description

### Field of the Invention

The present invention relates to a semiconductor device and a method of fabricating the same. In further detail, the present invention relates to a semiconductor device applied with so-called, multi-chip module (MCM) technology, having a plurality of semiconductor chips integrated into a single electronic component, and a method of fabricating the same.

### Description of Related Art

In order to satisfy demands on downsizing, reduction in weight and lower power consumption of electric appliances, development has been made on technologies not only for larger-scale integration of semiconductor elements, but also for mounting these semiconductor elements with a higher density. Of these mounting technologies, aiming at realizing mounting with a still higher density, in addition to multi-layered interconnection support substrate and bear chip mounting, there has been developed an MCM technology, by which a plurality of semiconductor elements (semiconductor chips) are preliminarily mounted on a single support substrate so as to be handled as a single electronic component to be mounted. The MCM technology can realize a substantial multi-functionalization, by incorporating two or more semiconductor chips onto a single substrate.

The semiconductor chip applied with the MCM technology has a plurality of semiconductor chips having an identical or different functions mounted on a single support substrate, in which each of the semiconductor chips has provided thereon internal circuits (core sections) having the individual functional elements formed therein, external connection circuits (so-called interface circuits) drawn out from the individual internal circuits, and electrode pads connected to the external connection circuits. Each of the semiconductor chips is connected by a wiring provided between the electrode pads. The electrode pads are used not only for inter-chip connection, but also as probe lands in functional inspection.

This sort of MCM-type semiconductor device makes it possible to simplify the design process and wafer process as compared with system-LSI-type semiconductor device having functions of a plurality of semiconductor chips integrated into a single semiconductor chip, while realizing an equivalent level of higher functionalization, and is consequently advantageous in view of yield rate, production cost, and shortening of TAT (turn around time).

In the connection of internal circuits of a plurality of semiconductor chips of a conventional MCM-type semiconductor device, signal lines derived from the internal circuits are once drawn out to external connection circuits, and are then connected to the external connection circuits provided to the other semiconductor chip. This raises a problem of degradation in the reliability, due to increase in the power consumption of the external connection circuits and consequent increase in heat generation in the semiconductor devices. Another problem resides in that the external connection circuits are causative of space loss.

Still another problem resides in that the interconnection from the internal circuit to the external connection circuit within the semiconductor chip may sometimes need a long roundabout of the interconnection between a point of signal generation inside the chip and a destination of the signal outside the chip, and this results in lowering of rate of signal transmission, and makes high-speed operation difficult.

As one exemplary technique of solving these problems, there is proposed a technique of separating the external connection circuit mounted for the convenience of connection with the external of the chip, in such a way that, out of a plurality of semiconductor chips, at least one of which is configured only by a core section, and that the core section is connected to an external instrument or other chips, typically as described in Japanese Patent Application Publication (KOKAI) No. HEI 7-153902. This technique makes it possible to prevent space loss of the chip, and to achieve lower power consumption and higher operation speed.

However, the technique described in Japanese Patent Application Publication (KOKAI) No. HEI 7-153902, attributable to the connection between the core section and an external instrument or the other chip, was found to sometimes result in a case of degradation in characteristics or destruction (generally referred to as electrostatic damage) of the elements used for the in-chip circuit, when interconnection wire (bonding wire) was used for the connection with an external instrument (including the other semiconductor chip with respect to one semiconductor chip), due to electric charge on the semiconductor chip flowing into the inter-chip signal lines.

It was also found that flip-chip method and TAB (tape automated bonding) method, both using bumps (protruded electrodes) for ensuring the inter-chip connection, may sometimes result in degradation in characteristics or destruction (generally referred to as plasma damage) of the elements used for the in-chip circuit, due to plasma damage possibly caused when the bumps are formed on the surface of the chips.

The problems of electrostatic damage and plasma damage are undesirable because they are causative of degradation in the reliability and yield rate of the MCM.

The present invention was conceived after considering the above-described situation, and an object thereof is to provide an MCM-type semiconductor device allowing high-speed operation and reduction in power consumption, as well as being capable of preventing reliability and yield rate of MCM from degrading, and a method of fabricating the same.

### Disclosure of the Invention

A semiconductor device of the present invention was configured so that signal lines connecting the internal circuits respectively formed in a plurality of semiconductor chips are connected in an electrically direct manner; and so that a first protection circuit was provided so as to prevent the semiconductor elements on the chips from being damaged by the connection of the signal lines connecting the internal circuits with each other.

Finished forms of the semiconductor device are not limited to those having a plurality of semiconductor chips arranged side by side on a flat surface of a common support substrate (interposer or mother board), and allow stacking (face-down mounting) of a plurality of semiconductor chips. In the latter case, one of the semiconductor chips can be assumed as being used substantially as a support substrate for the other, and this makes it no more necessary to obtain an additional interposer, and consequently makes it possible to realize a low-cost MCM device needing no cost for the interposer.

According to a method of fabricating a semiconductor device of the present invention, first, functional inspection of the internal circuits is carried out for each of the plurality of semiconductor chips, while mounting the first protection circuit provided in order to prevent the semiconductor elements in the internal circuits from being damaged by the electrical and direct connection between one internal circuit and the internal circuit on the other semiconductor chip.

Thereafter, keeping a condition of mounting at least the first protection circuit thereon, the signal lines between the both internal circuits are electrically and directly connected. Technique for the connection is preferably such as using bonding wires or bumps.

For a case where the external connection circuit is formed in an area intended for the connection (target connection area) in the semiconductor chip, it is preferable to once electrically separate at least a portion of the external connection circuit at the target connection area from the signal line (or the internal circuit side), and to then connect the signal lines between both internal circuits in an electrically direct manner.

Techniques for the separation adoptable herein include a method of disconnecting only the signal wiring derived from the internal circuit typically by laser blow or dry etching such as RIE (reactive ion etching), and a method of physically cutting and removing (disconnecting) portions of the semiconductor chip at the target connection area. By these techniques, it is made possible to disuse the entire portion or part of the external connection circuit at the target connection area, and thereby to suppress the power consumption and to prevent a problem of signal delay from occurring.

The first protection circuit, provided on the signal line directly connecting both internal circuits, is preferably arranged, in at least one of, and preferably both of a plurality of semiconductor chips, on the signal line between the connection area of the other internal circuit and the internal circuit of one semiconductor chip.

For a case where the external connection circuit has a second protection circuit protecting the semiconductor element from any damage possibly caused by connection with an external instrument, the first protection circuit is provided on the above-described signal line directly connecting the internal circuits. The first and second protection circuits are substantially provided in a separate manner.

The first protection circuit is aimed at protection from the damage possibly occurs when the internal circuits of both chips are directly connected, so that the protection performance thereof may be sufficient if only it accomplishes the object. Although the second protection circuit may occasionally be provided also in the external connection circuits used for connection with an external instrument or functional inspection, for the purpose of protecting the semiconductor elements from damage possibly occurs during the connection, it is not always necessary for the first protection circuit to have the protection performance equivalent to the protection performance of the second protection circuit.

The first protection circuit is aimed at protection from the damage possibly occurs when the internal circuits of both chips are directly connected, and will be no more necessary after completion of the connection step. Or rather, absence of the first protection circuit is more preferable, because presence of this protection circuit on the signal line serves as a load imposed on the signal line.

After completion of the connection step, it is therefore preferable to electrically separate the first protection circuit from the signal lines. As a technique for the separation, it is allowable to use not only laser blow or dry etching such as RIE (reactive ion etching), but also a switching circuit capable of ON/OFF switching between the input/output, which is kept turned on in the connection step so as to activate the protection circuit, and is turned off after completion of the connection step so as to separate the first protection circuit from the signal lines.

It is to be noted that also the switching circuit may serve as a load on the signal line, so that it is preferable, in the device circuit design, to determine whether the provision of the switching circuit is appropriate or not, taking the individual circuit configurations of the protection circuit and the switching circuit, and their resultant loads on the signal lines into consideration.

According to the above-described configuration of the present invention, the direct electrical connection of the internal circuits can make it possible to suppress the power consumption in the device and prevent the device from operation delay, and allowed for high speed operation, as compared with the case where the connection is established via the external connection circuits.

In addition, the semiconductor device was configured as providing the protection circuit protecting the semiconductor elements on the chips from being damaged by static electricity and plasma during the inter-circuit connection, on the signal line connecting internal circuits in an electrically direct manner, so that it is made possible to protect the elements from the damage in the process of connecting the internal circuits in an electrically direct manner or in the process of forming the protruded electrodes for connection, and thereby makes it possible to prevent the reliability and yield rate of the MCM device from being degraded.

In short, even if the MCM-type semiconductor device, having a plurality of semiconductors are mounted thereon, is fabricated so that the entire portion or a part of the external connection circuit is separated from the internal circuit side aiming at downsizing, lower power consumption and higher speed, the semiconductor device makes it possible to improve the reliability and yield rate of MCM, at the same time the downsizing, lower power consumption and higher speed are achieved, by providing the protection circuit on the signal line directly connecting the internal circuits.

### Brief Description of the Drawings

Fig. 1 is a plan view showing a first embodiment of a semiconductor device applied with the present invention.
Fig. 2A to Fig. 2C are drawings explaining an exemplary configuration of an external connection circuit, and a technique of connecting in-chip circuits in an inter-chip connection area (part 1).
Fig. 3A to Fig. 3C are drawings explaining an exemplary configuration of the external connection circuit, and the technique of connecting the in-chip circuits in an inter-chip connection area (part 2).
Fig. 4A to Fig. 4C are drawings explaining a method of fabricating a semiconductor device 1 of the first embodiment.
Fig. 5A and Fig. 5B are drawings explaining a second embodiment of the semiconductor device applied with the present invention.
Fig. 6A and Fig. 6B are drawings explaining a third embodiment of the semiconductor device applied with the present invention (part 1).
Fig. 7A and Fig. 7B are drawings explaining the third embodiment of the semiconductor device applied with the present invention (part 2).
Fig. 8 is a sectional view showing a fourth embodiment of the semiconductor device applied with the present invention.

### Best Modes for Carrying out the Invention

Next paragraphs will detail embodiment of the present invention referring to the attached drawings. It is to be noted that any identical constituents appear in the individual embodiments described below will be given with the same reference numeral, allowing omission of repetitive explanation. The semiconductor devices of these embodiments are configured so that the in-chip circuits formed on a plurality of semiconductor chips are connected in an electrically direct manner, adopting the technique of separating the external connection circuit mounted for the convenience of connection with the external of the chips, proposed by the present applicant in Japanese Patent Applications No. 2002-67969 and No. 2002-191064, and at the same time as a configuration specific to the present invention, so that the protection circuit is provided on the signal lines connecting the in-chip circuits in an electrically direct manner. Specific explanation will be given below.

### <First Embodiment>

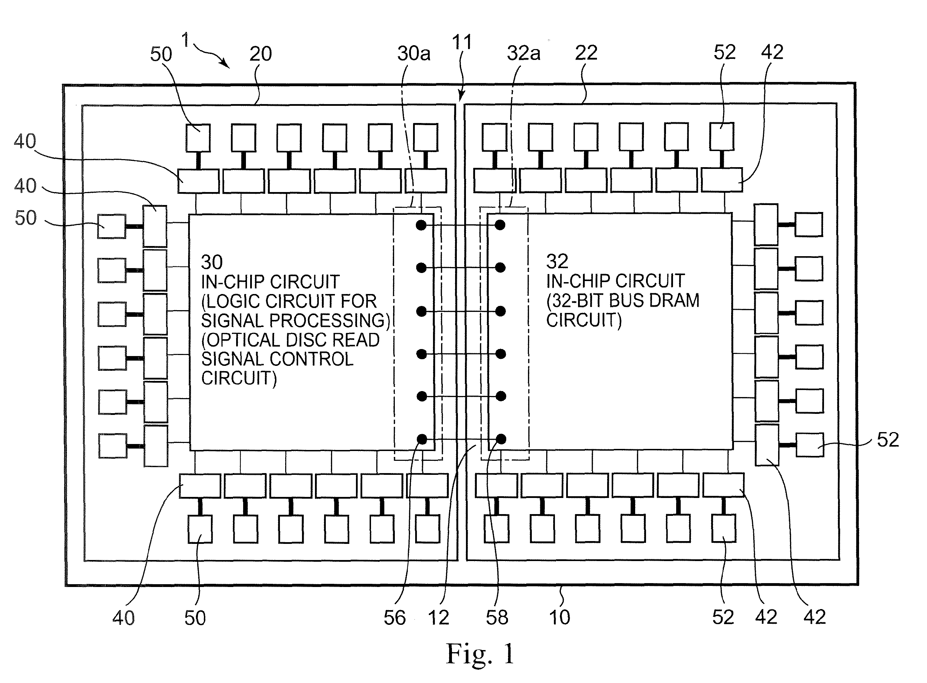

Fig. 1 is a plan view showing a first embodiment of a semiconductor device applied with the present invention. The semiconductor device 1 shown in the drawing is a so-called, MCM-type semiconductor device having a plurality of (two in Fig. 1) substantially square semiconductor chips 20, 22 mounted on a support substrate 10.

A first semiconductor chip 20 is typically a semiconductor chip for logic use, having a logic circuit for signal processing formed therein as an in-chip circuit 30. On the other hand, a second semiconductor chip 22 is a semiconductor chip for memory use, having a DRAM (dynamic RAM) circuit with a 32-bit bus formed therein as an in-chip circuit 32. It is to be noted that configurations of the in-chip circuits 30, 32 of the semiconductor chips 20, 22 are not limited thereto.

The semiconductor chips 20, 22 are typically die-bonded on the support substrate 10, directing the circuit formation surface thereof upward. On the support substrate 10, an insulating film, not shown, is formed so as to cover the semiconductor chips 20, 22.

The semiconductor chips 20, 22 have a plurality of external connection circuits 40, 42 respectively derived from the in-chip circuits 30, 32, and electrode pads 50, 52 connected to the individual external connection circuits 40, 42.

The electrode pads 50, 52 are provided for allowing functional inspection of the semiconductor chips 20, 22, and are arranged, typically as shown in Fig. 1, along the outer circumferences of the individual semiconductor chips 20, 22.

On the other hand, an inter-chip connection area 11 between the semiconductor chips 20, 22 has no electrode pads 50, 52 formed therein. It is designed so that the semiconductor chips 20, 22 are connected by connecting the in-chip circuits 30, 32 at connection points 56, 58 in connection areas 30a, 32a by directly using interconnection wires 12, without placing the electrode pads 50, 52 nor external connection circuits 40, 42 in between. The phrase "without placing the electrode pads nor the external connection circuits in between" means "without allowing any electric signals to pass through these components".

Because the electrode pads 50, 52 and the external connection circuits 40, 42 in the inter-chip connection area 11 become substantially unnecessary after the semiconductor device 1 is finished, it is also allowable, for example, to physically separate the electrode pads 50, 52 in the inter-chip connection area 11 from the external connection circuits 40, 42 to be separated, to thereby make the both more closer at the inter-chip connection area 11. Fig. 1 shows this configuration.

It is also allowable to electrically separate interconnection areas (not shown) between the in-chip circuits 30, 32 by laser blow or a dry etching technique such as RIE (reactive ion etching), while leaving the electrode pads 50, 52 and the external connection circuits 40, 42 in the inter-chip connection area 11 physically remained, similarly to those on three other edges, and to make connection at the connection points 56, 58 on the in-chip circuits 30, 32 sides in the vicinity of site of separation, using the interconnection wires 12.

It is still also allowable to provide, between the external connection circuit 40a(42a) to be separated and the in-chip circuit 30(32), a switching circuit (isolation circuit) capable of electrical ON/OFF switching between the both, or electrically connecting and disconnecting the both, while leaving the electrode pads 50, 52 and the external connection circuits 40, 42 in the inter-chip connection area 11 physically remained, similarly to those on three other edges. Circuit configuration of a control section corresponding to the switching circuit may be such as allowing control by external signals, or may be such as automatically detecting connection of the in-chip circuits 30, 32 by the interconnection wires 12 when the connection is established, and as electrically separating the external connection circuits 40, 42 in the inter-chip connection area 11 from the in-chip circuits 30, 32.

The interconnection wires 12 directly connecting the in-chip circuits 30, 32 are typically provided on the above-described insulating film by patterning, and are connected to the in-chip circuits 30, 32 of the individual semiconductor chips 20, 22, at the connection points 56, 58 in portions of the connection areas 30a, 32a formed in the insulating film, through connection holes not shown.

The portions of the connection areas 30a, 32a to which the interconnection wires 12 are connected have sufficient areas for the connection, by configuring a part of interconnections (signal lines) composing the in-chip circuits 30, 32 as having a form of electrode pads, or by connecting the electrode pads to the signal lines.

As another specific configuration of the present invention, in the connection areas 30a, 32a, there is provided a protective component protecting the unillustrated semiconductor elements used for the in-chip circuits 30, 32, from electrostatic discharge possibly caused when the chips are connected due to electric charge accumulated on the chips, or from plasma damage possibly given when the bumps used for the electrical connection are formed on the surface of the chips. This point will be detailed later.

### <External Circuit and Protected Inter-Chip Connection>

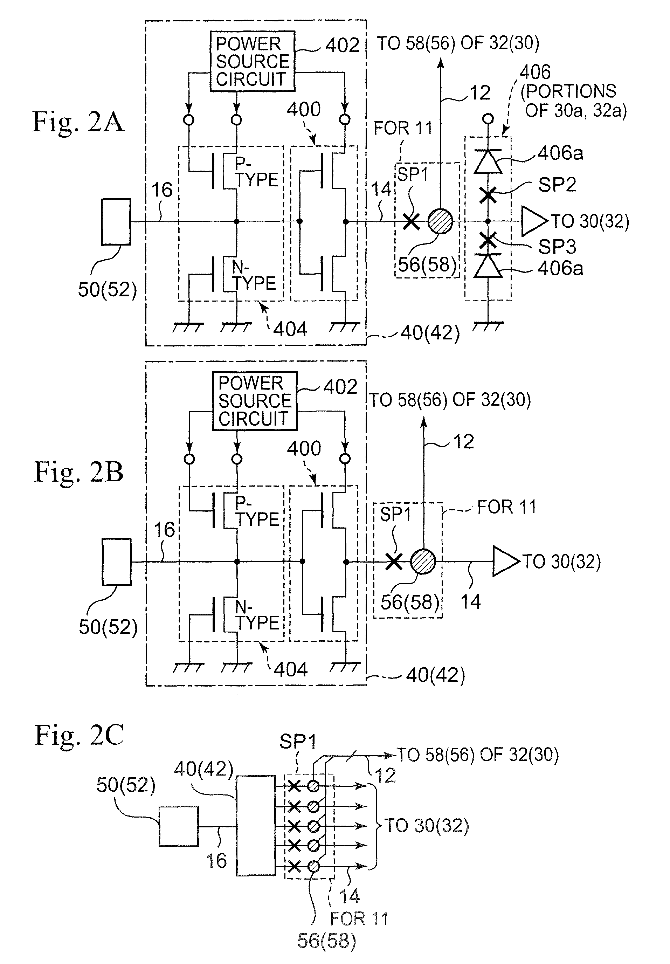

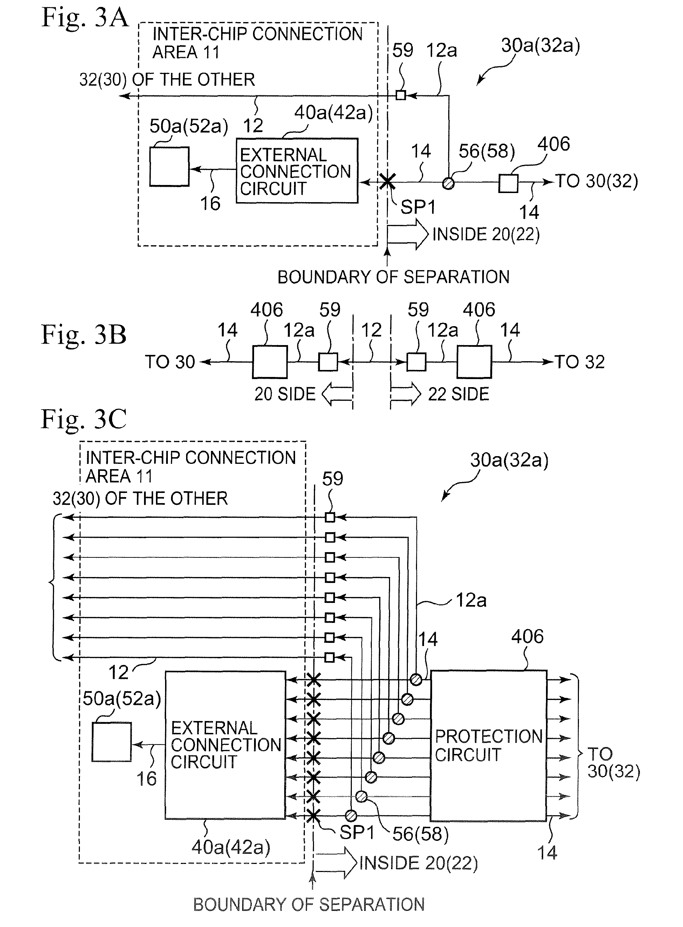

Fig. 2A to Fig. 2C, and Fig. 3A to Fig. 3C are drawings explaining an exemplary configuration of the external connection circuits 40, 42 and a method of connecting the in-chip circuits 30, 32 in the inter-chip connection area 11. Fig. 2A and Fig. 3A herein show an exemplary technique of one embodiment of the present invention, and Fig. 2B shows one example of the technique disclosed in Japanese Patent Applications No. 2002-67969 and No. 2002-191064. Fig. 2C and Fig. 3C show modified examples of the configuration in the vicinity of the external connection circuits 40, 42 in the inter-chip connection area 11.

The external connection circuits 40, 42 typically comprise, as shown in Fig. 2A and Fig. 2B, an I/O (input/output, I:input, O:output) circuit 400, a power source circuit 402, and an electrostatic protection circuit (one example of the second protection circuit of the present invention) 404. When the functions are inspected, a probe for testing the chip is brought into contact with each of the electrode pads 50(52) connected to a draw-out interconnection 16 independently drawn via the external connection circuit 40(42) from the correspondent internal interconnection 14.

Although the drawing shows the power source circuit 402 provided to each of the external connection circuits 40, 42, it is also allowable, in place providing the power source circuit 402 to every external connection circuits 40, 42, to provide one power source circuit 402 for every predetermined numbers of, or for all of the external connection circuits 40, 42.

It is also allowable, as shown in Fig. 2C, that the individual external connection circuits 40(42) and the electrode pads 50(52) are configured to be shared by a plurality of (five in the drawing) internal interconnections 14 drawing out the in-chip circuit 30(32), and it is transmitted through a single draw-out interconnection 16 to the electrode pad 50(52). In this case, the external connection circuit 40(42) is configured typically so as to make an unillustrated I/O circuit in the external connection circuit 40(42) execute processes of accumulating the signals from the in-chip circuit 30(32), sending the signals out from the chip after serial signal processing, and decoding the signals again into the original ones by the reverse signal processing.

In the external connection circuit 40(42) configured as shown in Fig. 2C, the internal interconnections 14 derived from the in-chip circuit 30(32) are connected to the external connection circuit 40(42), in which the serial signal processing is executed, and are connected to the electrode pads 50(52) smaller in the number of provision than the internal interconnections 14. For the inter-chip connection area 11, the individual internal interconnections 14 derived from the in-chip circuit 30(32) side are designed to be connected, at the connection point 56(58) in a preceding stage of the external connection circuit 40(42), also to the connection points 58(56) of the other semiconductor chip 20. In the functional inspection, a probe for a chip test is brought into contact with thus-shared electrode pad 50(52). This makes it possible to carry out the functional inspection with pins smaller in the number and using the electrode pads 50(52) smaller in the number of provision than the signal lines necessary for the test. For the inter-chip connection area 11, the individual internal interconnections 14 derived from the in-chip circuit 30(32) side are connected, at the connection points 56(58) in the preceding stage of the external connection circuit 40(42), also to the connection points 58(56) of the other semiconductor chip 20.

A predetermined number of thus-configured external connection circuits 40(42) are disposed on the periphery of the square semiconductor chips 20, 22, as shown in Fig. 1. On the other hand, for the inter-chip connection area 11, the in-chip circuit 30(32) side and the external connection circuit 40(42) side are electrically separated at separation points SP1.

For example, the internal interconnections 14 connecting the in-chip circuit 30(32) side and the external connection circuit 40(42) side are disconnected at the separation points SP1, and connected, at the connection points 56(58) more closer to the in-chip circuit 30(32) than the separation points SP1, to the connection points 58(56) on the other in-chip circuit 32(30) side, through the interconnection wires 12. By this configuration, in the inter-chip connection area 11, it is made possible to connect the in-chip circuits 30, 32 without being electrically mediated by the electrode pads 50, 52 nor the external connection circuits 40, 42.

In this stage, it is also allowable to disconnect the external connection circuits 40(42), which would be unnecessary at the time, not only electrically but also physically, or may be left unmodified. For a case where they are physically left, it is preferable to use a technique of electrically disconnect it, using a separation circuit, from the signal line.

More specifically, for the inter-chip connection area 11, as shown in Fig. 3A and Fig. 3B, the connection pads 59 through which connection with the other in-chip circuit 32(30) is established via the interconnection wire 12 are provided in the vicinity of the external connection circuit 40a(42a) to be separated, in the number corresponding to that of the internal interconnections 14. The connection pads 59 may be only as fine as allowing the connection with the other in-chip circuit 32(30), and may be far smaller than the electrode pads 50(52) also used as the probe lands for the functional inspection.

For the case of the external connection circuit 40 shown in Fig. 2C, the individual connection points 56(58) corresponded to the individual inner interconnections 14 are arranged in line (not only in a single line but also may be in a plurality of lines each containing every several pads), as shown in Fig. 3C, nearly in parallel with a boundary line of separation and on the semiconductor chip 20 side. The internal interconnections 14 and the connection pads 59 are connected with the internal draw-out lines 12a branched from the connection points 56(58).

Positions of disconnection of the external connection circuits 40a, 42a and the electrode pads 50a, 52a to be disconnected with respect to the in-chip circuits 30, 32 are realized by setting the boundary of separation on the separation points SP1 in the circuit diagrams shown in Fig. 2A to Fig. 2C, in which separation points SP1 are more specifically referred to also as positions between the in-chip circuits 30, 32 and the external connection circuits 40a, 42a, as shown in Fig. 3A and Fig. 3B, at which the connection pads 59 are left on the in-chip circuits 30, 32 side. Disconnection on the boundary of separation makes it possible to physically disconnect the external connection circuits 40a(42a) and the electrode pads 50a(52a) from the semiconductor chips 20(22).

In thus-configured semiconductor device 1, a part (portion between the chips connected to each other) of each of input/output (I/O) circuit 400, the power source circuit 402, and the electrostatic protection circuit 404 are disconnected from the semiconductor chips 20, 22, and the semiconductor chip 20, 22 mounted on the support substrate 10 are directly connected between the portions of the in-chip circuit 30, 32 of the semiconductor chips 20, 22, without placing the external connection circuits 40, 42 in between.

By getting rid of using the external connection circuits 40, 42 which are circuits needing a large power consumption, it is made possible to reduce the power consumption in the external connection circuits 40, 42, as compared with the semiconductor device having the in-chip circuits 30, 32 of the semiconductor chips 20, 22 connected with each other, while placing the external connection circuits 40, 42 in between. It is also made possible to improve the reliability of the semiconductor device 1.

In addition, the individual semiconductor chips 20, 22 are connected in an electrically direct manner without placing the external connection circuits 40, 42 (I/O circuit 400, for example) in between, so that it is made possible to avoid operation delay possibly caused by connection of the semiconductor chips 20, 22 while placing the external connection circuits 40, 42 in between, and to achieve high-speed operation of the semiconductor device 1.

It is also characterized in that the semiconductor chips 20, 22 are directly connected between the portions of the in-chip circuits 30, 32 of the semiconductor chips 20, 22 without placing the external connection circuits 40, 42 in between, but also in that no excessive external connection circuit is connected at the portions of the in-chip circuits 30, 32. This successfully prevents current from flowing into the excessive external connection circuits, and makes it possible to exactly reduce the power consumption, to save area of the semiconductor chips allowed for the excessive external connection circuits, and to downsize the semiconductor device.

In particular, for the case where the external connection circuits 40, 42 are shared by a plurality of internal interconnections 14 drawing out the in-chip circuits 30, 32, as explained referring to Fig. 2C, a large power is consumed by the external connection circuits 40, 42, whereas the connection portions between the in-chip circuits 30, 32, having no such external connection circuits 40, 42 provided therein, can suppress the power consumption to a large degree.

It is, however, to be noted that electrostatic discharge due to electric charge accumulated on the chip may occur when, as shown in Fig. 2B, the external connection circuits 40, 42 are disconnected at the separation point SP1, and the chips are connected by directly connecting the in-chip circuits 30, 32 with the interconnection wires 12. This may result in characteristic degradation or destruction of the unillustrated semiconductor elements used for the in-chip circuits 30, 32.

For the purpose of protecting the semiconductor elements used for the in-chip circuits 30, 32 from such electrostatic discharge in the process of connection of the chips and from plasma damage in the process of bump formation on the surface of the chips caused by electric charge on such chips, the configuration of the present embodiment adopts protective components for coping with these problems provided between the inter-chip connection area 11 and the in-chip circuits 30, 32. More specifically, as shown in Fig. 2A, Fig. 3A and Fig. 3C, the portions of the connection area 30a(32a) of the semiconductor chip 20(22) has, as being provided therein, the protection circuit (an example of the first protection circuit of the present invention) 406, which comprises diodes 406a or the like, aimed at protecting the chip from the electrostatic damage.

The protection circuit 406 may be provided elsewhere on the signal line (interconnection wire 12, internal draw-out line 12a, internal interconnection 14) connecting the in-chip circuits 30, 32 of the semiconductor chips 20, 22 in an electrically direct manner. In view of exactly protecting the semiconductor elements of the individual in-chip circuits 30, 32, it is preferable as shown in Fig. 3B to provide, on each semiconductor chip 20(22), the protection circuit 406 on the internal interconnection 14 or on the internal draw-out line 12a, between each connection pad 59 and the in-chip circuit 30(32).

Although not always being considered as a preferable technique, it is also allowable, for example, to make the connection via a junction pad base and a junction pad, so as to allow connection of one in-chip circuit 30(32) once to the junction pad base, and so as to allow further connection from the junction pad base to the other in-chip circuit 32(30). Positions of arrangement of the protection circuits 406 in this case preferably fall, similarly to as described in the above, on the internal interconnection 14 or on the internal draw-out line 12a, between each connection pad 59 and the in-chip circuit 30(32), on each semiconductor chip 20(22).

Again although not always being a sufficient embodiment in view of ability of protecting the semiconductor elements on the semiconductor chips 20, 22 from electrostatic damage, it is also allowable to dispose the protection circuit 406 at the junction pad base. This embodiment raises an advantage in that it is made possible to select and use the protection circuit 406 having an appropriate protection ability, corresponding to difference in generation state of static electricity which depends on environmental conditions, despite the common semiconductor chips 20, 22 are used.

Because tolerance of the semiconductor elements to electrostatic discharge, owned by the in-chip circuits 30, 32 on the respective semiconductor chips 20, 22 are not always equivalent, it is therefore allowable, for example, to provide the protection circuit 406 only to the less resistant one. In this case, because the resistance may even differ by every signal line, it is still also allowable to independently dispose the protection circuits 406 at a position closer to the less-resistant chip by every signal line, such as on the semiconductor chip 20 side for a certain signal line, and on the semiconductor chip 22 side for another certain signal line.

The protection circuit 406 is aimed at protecting the elements from damage (electrostatic damage herein in particular) caused in the process of directly connecting the in-chip circuits 30, 32 of both of the semiconductor chips 20, 22, so that it is all enough for the protection circuit 406 to have a protection ability just as much as achieving its protective functions during the connection, and to exhibit its protection functions.

The protective functions of the protection circuit 406 may differ from those of the electrostatic protection circuit 404 provided in the external connection circuits 40, 42, used for connection with an external instrument, functional inspection and so forth. The external connection circuit 40, 42, which are targets to be compared therewith, may be the external connection circuits 40a, 42a disconnected from the semiconductor chips 20, 22 in the inter-chip connection area 11, or may be the external connection circuits 40, 42 provided to other peripheral portions. According to this configuration, provision of the protection circuit 406 having a smaller size makes it possible not only to improve the reliability and yield rate of the chips, but also to reduce the cost, while reducing the chip area.

Based on the similar reason, the protection circuit 406 becomes unnecessary after completion of the connection process. The protection circuit 406 would rather be absent on the signal line (internal interconnection 14 and internal draw-out line 12a in the foregoing example), because the protection circuit 406 residing thereon may serve as a load disposed on the signal line with respect to the in-chip circuits 30, 32. It is therefore preferable to electrically disconnect the protection circuit 406 from the signal line after completion of the process of connection between the in-chip circuits 30, 32. For example, in the configuration shown in Fig. 2A, it is preferable to disconnect the internal interconnection 14 and the diode 406a from each other at the separation points SP2, SP3 using laser blow or dry etching such as RIE.

According to the configuration in which the in-chip circuits 30, 32 are connected in an electrically direct manner in the inter-chip connection area 11, and the protection circuit 406 is provided on the signal line, it is made possible to protect the internal elements from electrostatic discharge in the process of chip connection, even if both chips are directly connected using the interconnection wires 12 after the external connection circuits 40, 42 are disconnected. This makes it possible to obtain the in-chip circuits 30, 32 having device characteristics similar to those shown before the external connection circuits 40, 42 are disconnected. This consequently results in improved reliability and yield rate of MCM device having low power consumption and high-speed operation property.

### <Method of Fabricating the Semiconductor Device>

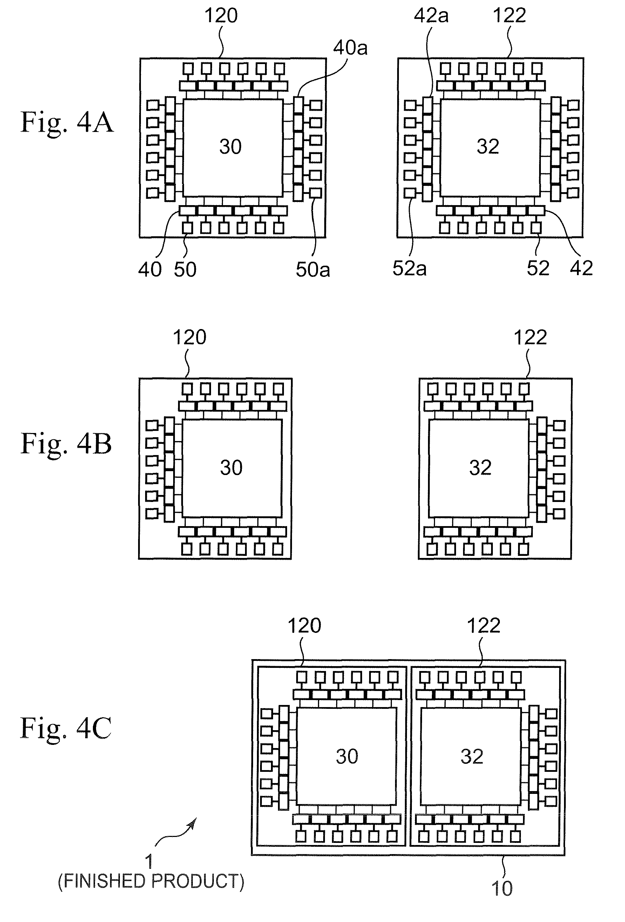

Fig. 4A to Fig. 4C are drawing explaining a method of fabricating the semiconductor device 1 of the first embodiment. As shown in Fig. 4A, the semiconductor chips 120, 122 are fabricated. The semiconductor chips 120, 122 are precursory forms of the semiconductor chips 20, 22 explained referring to Fig. 1, and have the in-chip circuits 30, 32, the external connection circuits 40, 42, and the electrode pads 50, 52 respectively formed therein. In particular, from the in-chip circuits 30, 32, the necessary and sufficient number of the external connection circuits 40, 42 for the functional inspection of the in-chip circuits 30, 32 are drawn out into four directions therearound. Accordingly, the number of the external connection circuits 40, 42 of the semiconductor chips 120, 122 and the number of the electrode pads 50, 52 herein are larger than the numbers of those in the semiconductor chips 20, 22 explained referring to Fig. 1. It is to be noted, that the external connection circuits 40a, 42a and the electrode pads 50a, 52a in the drawing are portions to be physically separated and removed in a later process step.

Of the external connection circuits 40, 42 drawn out from the in-chip circuits 30, 32, it is to be understood that portions of the in-chip circuits 30, 32, from which the external connection circuits 40a, 42a to be separated and removed in the later process step are drawn out, have formed therein the electrode pads (corresponded to the connection pads 59 shown in Fig. 3A to Fig. 3C), not shown. The electrode pads may be just as fine as allowing connection with the other chip.

Although not shown in the figure, it is assumed that the protection circuits 406 shown in Fig. 2A and Fig. 3A to Fig. 3C are provided on the connection signal lines (the internal interconnection 14 and the internal draw-out line 12a) between the in-chip circuits 30, 32 of the semiconductor chips 120, 122, connected to this electrode pads.

Next, thus-configured individual semiconductor chips 120, 122 are subjected to the functional inspection of their in-chip circuits 30, 32, by touching the electrode pads 50, 52, available also for inspection, with probes. In this process, the functional inspection of the individual semiconductor chips 120, 122 is preferably carried out in a wafer state having a plurality of semiconductor chips 120 formed thereon, and in a wafer state having a plurality of semiconductor chips 122 formed thereon.

Each of the individual semiconductor chips 120, 122 is then judged whether it is acceptable or should be rejected, the individual wafers are then ground from the back surface thereof to thereby divide it into the individual semiconductor chips 120, 122, and only those judged as being acceptable based on results of the functional inspection are then picked up.

After the above-described functional inspection, as shown in Fig. 4B, portions in which a part of the external connection circuits 40a, 42a and the electrode pads 50a, 52a of each of the semiconductor chips 120, 122 is provided is cut and removed (cut down) by dicing, at the same time the wafer is separated into the individual chips, to thereby shape the semiconductor chips 120, 122 into states of the semiconductor chips 20, 22 having the configuration explained referring to Fig. 1.

Another configuration making the cutting unnecessary uses chips previously made in a form of the semiconductor chips 20, 22, based on a layout having no electrode pads nor external connection circuits formed along one edge of the chip to be connected to internal connection circuits.

It is assumed that the external connection circuits 40a, 42a and the electrode pads 50a, 52a removed herein are the external connection circuits 40, 42 and the electrode pads 50, 52 provided at the portion to be connected with other semiconductor chip in the next process step. A position of disconnection of the external connection circuits 40a, 42a and the electrode pads 50a, 52a relative to the in-chip circuits 30, 32 falls on the boundary of separation leaving the connection pads 59 unremoved, as shown in Fig. 3A to Fig. 3C.

Next, as shown in Fig. 4C, the semiconductor chips 120, 122 are die-bonded on the support substrate 10. In this process, it is preferable to adopt a layout in which the connection portions of the individual semiconductor chips 120, 122 are disposed in proximity.

Thereafter, although not shown in the drawing, an insulating film is formed on the support substrate 10 so as to cover the individual semiconductor chips 120, 122, and further in the insulating film, connection holes reaching the connection pads provided to the in-chip circuits 30, 32 of the individual semiconductor chips 120, 122 are formed. The input and output are connected so as to make the protection circuits 406 function, and an interconnection is patterned on the insulating film so as to directly connect the in-chip circuits 30, 32 of the individual semiconductor chips 120, 122 through the connection holes, to thereby obtain the semiconductor device 1 shown in Fig. 1. More specifically, in the circuit configured as explained referring to Fig. 3A to Fig. 3C, the connection holes reaching the connection pads 59 are formed, and the connection pads 59 in each of the semiconductor chips 120, 122 are connected with each other using the interconnection wires 12.

After the in-chip circuits 30, 32 are connected, the protection circuit 406 which becomes no more necessary is disconnected from the signal line by laser blow or dry etching technique such as RIE.

In this method of fabrication, after the functional inspection of the in-chip circuits 30, 32 is carried out using the necessary and sufficient number of the external connection circuits 40, 42, connection between the semiconductor chips 120, 122 is established between the in-chip circuits 30, 32, with the unnecessary external connection circuits 40a, 42a disconnected from the in-chip circuits 30, 32.

The in-chip circuits 30, 32 herein are connected with the protection circuits 406 mounted, and the protection circuits 406 can absorb electric charge even if the electric charge accumulated on the semiconductor chips 120, 122 flows into the signal lines to be connected to, so that it is made possible to prevent characteristics of the elements used for the in-chip circuits from being degraded or destructed by static electricity. Disconnection of the protection circuits 406 from the signal lines after completion of the connection makes the protection circuits 406 no more function as loads of the in-chip circuits 30, 32 during normal operation, and this makes it possible to avoid lowering in the operation speed ascribable to the provision of the protection circuits 406.

It is therefore made possible to obtain the semiconductor device 1 having the in-chip circuits 30, 32 of the semiconductor chips 120, 122 connected therein through the connection pads 59 without causing any electrostatic damage, while using the semiconductor chips 120, 122 proven by the functional inspection to have a sufficient reliability, but without being mediated by the external connection circuits 40a, 42a used for the functional inspection, that is, to obtain the semiconductor device allowing reduction in power consumption and increase in the operation speed, and having a high reliability.

Although the above description dealt with only the disconnection of the protection circuits 406 from the signal lines, it is also allowable, for the case where the external connection circuits 40a, 42a in the inter-chip connection area 11 are remained physically undisconnected in the fabrication process, to provide a separation circuit electrically separating the external connection circuits 40a, 42a from the in-chip circuits 30, 32 side (see Japanese Patent Application No. 2002-67969 by the present applicant).

This makes it possible, for example, to connect the external connection circuits 40a, 42a when they are necessary as the time during the functional inspection of the in-chip circuits 30, 32, but to disconnect the external connection circuits 40a, 42a when they are not necessary, to thereby prevent unnecessary current from flowing into the external connection circuits 40a, 42a, and to exactly reduce the power consumption.

It is to be noted that the configuration having such separation circuit is applicable also to the configuration in which the external connection circuits 40a, 42a are shared by a plurality of internal interconnections 14 as explained referring to Fig. 2C. In this case, the separation circuit is provided between the internal circuit including the connection pads 59 and the external connection circuits 40a, 42a shown in Fig. 3C.

### <Second Embodiment>

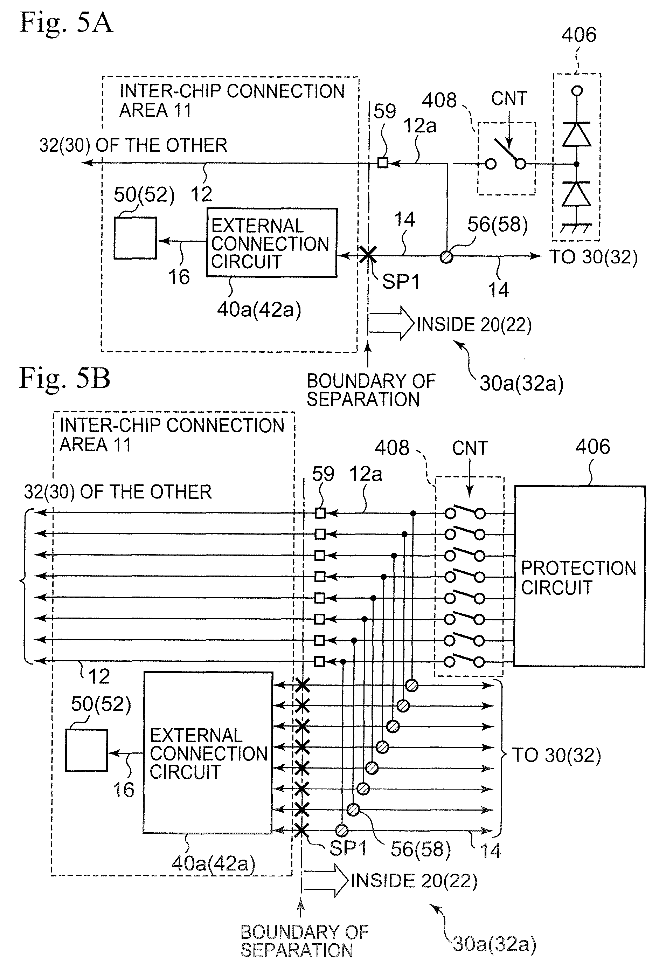

Fig. 5A and Fig. 5B are drawings explaining the second embodiment of the semiconductor device applied with the present invention. The drawings correspond to Fig. 3A to Fig. 3C for the second embodiment. The semiconductor device 1 of the second embodiment is characterized by using a switching circuit allowing ON/OFF switching between the input and the output, so as to configure the protection circuits 406 disconnectable from the signal lines directly connecting the in-chip circuits 30, 32. The plan view of the semiconductor device 1 can be understood as being basically equivalent to that shown in Fig. 1, except that the semiconductor chips 20, 22 have the switching circuit.

On the other hand, in a circuit configuration of the portion of the inter-chip connection area 11, typically as shown in Fig. 5A, there is provided a switching circuit 408 capable of ON/OFF switching between the input and output, between the connection pad 59 connected to the in-chip circuit 32(30) of the other semiconductor chip 22(20) and the protection circuit 406. The switching circuit 408 is provided as a switch switching connection state between the signal lines to which the connection pad 59 is connected (internal interconnection 14 and internal draw-out line 12a herein in the drawing) and the protection circuit 406, in response to an external signal CNT, and may be of a simple analog switch type.

The configuration provided with such switching circuit 408 is also applicable to a configuration in which the external connection circuits 40a, 42a are shared by a plurality of internal interconnections 14, as explained referring to Fig. 2C. In this case, the switching circuit 408 is provided between the internal circuit including the connection pads 59 and the protection circuit 406 shown in Fig. 3C.

As described in the above, in the semiconductor device 1 of the second embodiment, the electrical disconnection between the signal lines directly connecting the in-chip circuits 30, 32 and the protection circuit 406 is effected by the switching circuit 408. When the protection circuit 406 is necessary as in the case where the in-chip circuits 30, 32 are connected, it is therefore made possible to connect the protection circuit 406 on the signal line of a target of connection (that is, a target object to be protected), by turning the switching circuit 408 on, to thereby establish a connection state between the input and output.

On the other hand, at a point of time where the protection circuit 406 is no more necessary after completion of the connection between the in-chip circuits 30, 32, the protection circuit 406 is disconnected from the target of connection (that is, the target object to be protected), by turning the switching circuit 408 off, to thereby establish a disconnection state between the input and output. This makes it possible to prevent the in-chip circuits 30, 32 from being imposed with unnecessary loads, and to increase the operation speed.

### <Third Embodiment>

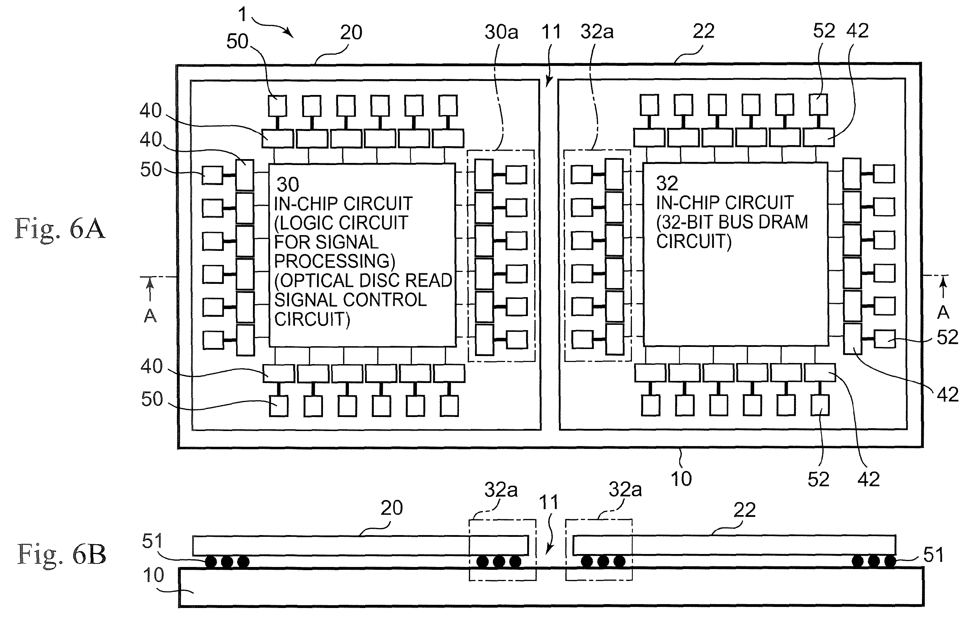

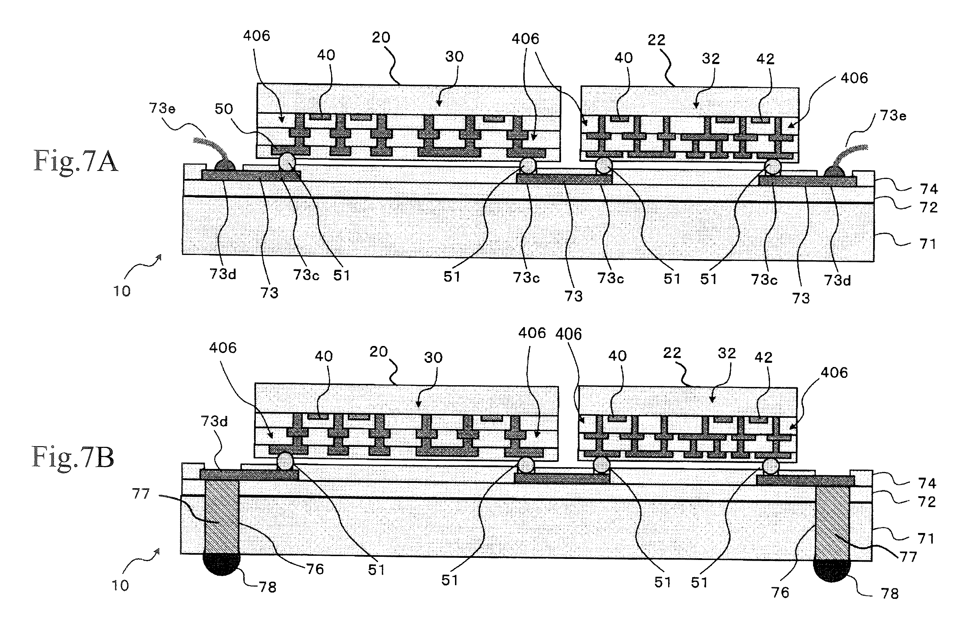

Fig. 6A and Fig. 6B, and Fig. 7A and Fig. 7B are drawings explaining the third embodiment of the semiconductor device applied with the present invention. Fig. 6A is a plan view showing the third embodiment, and Fig. 6B is a sectional view taken along a line A-A in the plan view. Fig. 7A and Fig. 7B are drawings showing details of the section taken along the line A-A in the plan view of Fig. 6A.

As shown in Fig. 6A and Fig. 6B, and Fig. 7A, the semiconductor device 1 of the third embodiment is characterized in that the semiconductor chips 20, 22 are mounted in a face-down manner using the bumps. Other configurations are almost same with those of the first or second embodiment, in which the protection circuits 406 are provided on the signal lines directly connecting the in-chip circuits 30, 32 in the inter-chip connection area 11. The protection circuits 406 are used not only for the purpose of protecting the semiconductor elements from electrostatic damage possibly caused when the in-chip circuits 30, 32 are directly connected similarly to as described in the first or second embodiment, but also for the purpose of protecting the semiconductor elements from plasma damage possibly caused when the protruded electrodes (bumps) used for the face-down mounting are formed at predetermined positions.

It is to be noted herein that the following description will be made on an exemplary case where the semiconductor chips 20, 22 are mounted in a face-down manner while leaving the external connection circuits 40a, 42a physically uncut and unremoved.

In the semiconductor device 1 of the third embodiment, the semiconductor chips 20, 22 are mounted in a face-down manner using the protruded electrodes 51, an example of bumps, on the support substrate (interposer in this case) 10. The support substrate 10 is configured typically to have a high-density interconnection 73 formed on a silicon substrate 71 while placing an insulating film 72 therebetween. A part of the interconnections 73 is formed in a style of electrode pad, so as to allow only the portions of the electrode pads 73c, 73d to expose, while leaving the other interconnections 73 covered with an insulating film 74. The electrode pads 73c herein are electrode pads used for connecting the semiconductor chips 20, 22 with the support substrate 10. On the other hand, the electrode pads 73d are electrode pads used for connecting the support substrate 10 and an external instrument, and are typically disposed on the circumferential portion of the support substrate 10.

Connection between the semiconductor chips 20, 22 is established by the protruded electrodes 51, and the interconnections 73 on the support substrate 10 which are connected to the protruded electrodes 51. The protruded electrodes 51 are held between a part of the interconnections composing the in-chip circuits 30, 32 of the individual semiconductor chips 20, 22, for example, a portion of the topmost layer of the multi-layered interconnection shown in the drawings, formed in a style of electrode pads, or the connection pads 59 shown in Fig. 3A to Fig. 3C, and the electrode pads 73c on the support substrate 10. This makes it possible to directly connect the in-chip circuits 30, 32 of the individual semiconductor chips 20, 22, without being mediated by the external connection circuits 40, 42 containing I/O circuits and so forth.

In order to connect the semiconductor chips 20, 22 with an external instrument, also the electrode pads 50, 52 provided to the semiconductor chips 20, 22 are connected to the electrode pads 73c of the interconnections 73 formed on the support substrate 10 side, via the protruded electrodes 51. The interconnections 73 having the electrode pads 50, 52 connected thereto are drawn out into the circumferential portion of the support substrate 10, and thus drawn-out portions of the interconnections are provided with the external electrode pads 73d used for connection with the external.

The electrode pads 50, 52 are connected to the in-chip circuits 30, 32 of the semiconductor chips 20, 22 via the external connection circuits 40, 42, by which the in-chip circuits 30, 32 of the semiconductor chips 20, 22 and the external electrode pads 73d on the support substrate 10 are connected through the external connection circuits 40, 42.

The semiconductor device 1 of the third embodiment establishes connection with an external instrument by connecting bonding wires 73e to the external electrode pads 73d. The external electrode pads 73d herein are also used for testing any semiconductor device configured as a multi-chip module.

As shown in Fig. 7B, it is also allowable to use a support substrate 10 having external substrate connection holes 76, which reach the external electrode pads 73d, provided in the silicon substrate 71 and the insulating film 72. Each of the external substrate connection holes 76 has a plug 77 composed of a conductive material filled therein, and on the surface of the plugs 77 (surface on the silicon substrate 71 side), there are provided protruded electrodes 78 connecting the semiconductor device to an external instrument. The protruded electrodes 78 are also used for testing any semiconductor device configured as a multi-chip module. The surface of the external electrode pads 73d may be exposed out from the insulating film 74 as shown in the drawing, or may be covered with the insulating film 74.

A method of fabricating the semiconductor device 1 of the third embodiment is as follows. First, similarly to the first embodiment, the individual semiconductor chips, respectively having the internal circuits, the external connection circuits and the connection pads formed therein, are fabricated on the surface of a wafer as precursory forms of the semiconductor chips 20, 22 shown in Fig. 6A and Fig. 6B, and the connection pads are touched with probes for functional inspection of the individual internal circuits of the individual semiconductor chips. Thereafter, the wafer is separated into the individual semiconductor chips 20, 22 shown in Fig. 6A and Fig. 6B, and only those accepted by the functional inspection are picked up. It is to be understood that, on the signal lines (internal interconnections 14 shown in Fig. 2A, and Fig. 3A to Fig. 3C, and internal draw-out lines 12a) between the in-chip circuits 30, 32 on the semiconductor chips 20, 22, connected to the portions where the protruded electrodes 51 are to be formed later, there are provided the protection circuits 406 shown in Fig. 2A, and Fig. 3A to Fig. 3C.

On the semiconductor chips 20, 22, under provision of the protection circuits 406 on the signal lines, the protruded electrodes 51 are formed on the electrode pads 50, 52 kept in connection with the in-chip circuits 30, 32, and on portions of the in-chip circuits 30, 32 which serve as connection portions with other semiconductor chips. The protruded electrodes 51 are preferably formed on a wafer before being separated into the semiconductor chips 20, 22. It is also allowable to form the protruded electrodes 51 on the support substrate 10 side, not on the semiconductor chips 20, 22 side. It is still also allowable to from them on both of the semiconductor chips 20, 22 and the support substrate.

The state of provision of the protection circuits 406 on the signal lines means a state in which the protection circuits 406 are functionalized, and means, for the case where the semiconductor chips 20, 22 have the switching circuits 408 provided between the signal lines and the protection circuits 406, a state in which the input and output thereof are connected. The same will apply also to the description below.

Thereafter, under provision of the protection circuits 406 on the signal lines, the semiconductor chips 20, 22 are mounted on the support substrate 10, having the interconnections 73 and the electrode pads 73c, 73d formed thereon, so as to oppose therewith the surface having the in-chip circuits 30, 32 formed thereon. In this process, the in-chip circuits 30, 32 of the semiconductor chips 20, 22 are directly connected while being mediated by the interconnections 73 on the support substrate 10 and the protruded electrodes 51. The semiconductor device 1 is thus completed by the process.

Also by thus-configured semiconductor device 1 and the method of fabricating the same according to the third embodiment, it is made possible to obtain a semiconductor device allowing reduction in power consumption and increase in the operation speed, while using the semiconductor chips 20, 22 proven by the functional inspection to have a sufficient level of reliability, similarly to as described in the above-described first and second embodiments, because the in-chip circuits 30, 32 of the semiconductor chips 20, 22 are directly connected by the interconnections 73 on the support substrate 10 side.

In addition, the protection circuits 406 are provided on the signal lines having the protruded electrodes 51, an example of bumps, formed thereon, and the protection circuits 406 can absorb the plasma current, which is possibly generated during formation of the bumps (protruded electrodes 51 herein) on the surface of the chips, and possibly flows into the target signal lines on which the protruded electrodes 51 will be formed, so that it is made possible to prevent characteristics of the elements used for the in-chip circuits from being degraded or destructed by the plasma current.

Because the in-chip circuits 30, 32 of the semiconductor chips 20, 22 are connected in an electrically direct manner by connecting the protruded electrodes 51 and the interconnections 73 on the support substrate 10, under provision of the protection circuits 406 on the signal lines, the protection circuits 406 can absorb the electric charge even if the electric charge accumulated on the semiconductor chips 20, 22 should flow into the target signal lines to be connected, and this makes it possible to prevent the characteristics of the elements used for the in-chip circuits from being degraded or destructed by the static electricity.

The protection circuits 406 will no more function as a load of the in-chip circuits 30, 32 during the normal operation, if the protection circuits 406 are disconnected from the signal lines after completion of the connection, or the face-down mounting. This makes it possible to prevent the in-chip circuits 30, 32 from being imposed with an unnecessary load, and to achieve a high-speed operation.

For the case where the silicon substrate 71 is used as the support substrate 10 in the semiconductor device 1 according to the third embodiment, it is made possible to form the interconnections 73 with a high density on the support substrate 10 side, and to connect the semiconductor chips 20, 22 with a minimum distance. This makes it possible to further prevent the signal delay and to achieve a higher operation speed. Furthermore, in a case of using silicon substrates for both of the support substrate 10 and the semiconductor chips 20, 22, it is made possible to prevent breakage of the interconnection at the joint portions due to heat stress (possibly caused by the protruded electrodes 51), because the expansion coefficient of the both are same. Use of the silicon substrate, having a larger heat conductivity as compared with organic substrates, as the support substrate 10 also makes it possible to prevent any heat-induced malfunction of the semiconductor chips 20, 22, even if they are heated up by operation of the in-chip circuits 30, 32, because the silicon substrate can more rapidly dissipate the heat.

### <Fourth Embodiment>

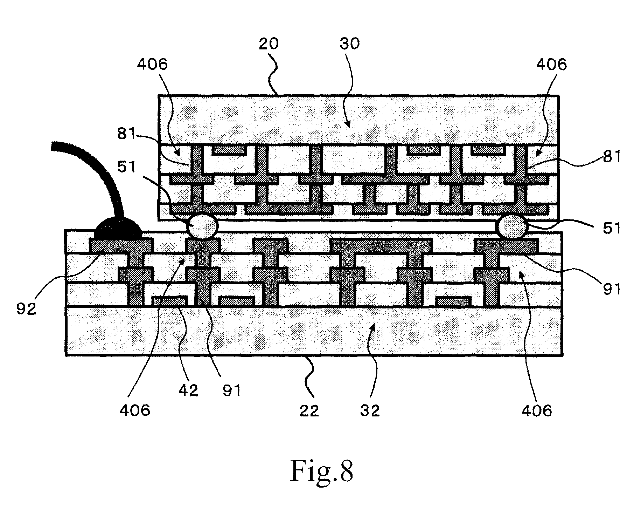

Fig. 8 is a sectional view showing the fourth embodiment of the semiconductor device applied with the present invention. The semiconductor device 1 of the fourth embodiment is characterized in that the semiconductor chips 20, 22 are mutually mounted face down. Other configuration are similar to those in the configurations of the first or second embodiment, and the protection circuits 406 are provided on the signal lines directly connecting the in-chip circuits 30, 32 in the inter-chip connection area 11.

The protection circuits 406 are aimed similarly to the third embodiment, and are used not only for the purpose of protecting the semiconductor elements from electrostatic damage possibly caused when the in-chip circuits 30, 32 are directly connected with each other, but also for the purpose of protecting the semiconductor elements from plasma damage possibly caused when the protruded electrodes (bumps) used for the face-down mounting are formed at predetermined positions.

As shown in Fig. 8, in the semiconductor device 1 of the fourth embodiment, the semiconductor chip 20 serves as a support substrate for the semiconductor chip 22, and the semiconductor chip 22 serves as a support substrate for the semiconductor chip 20, and the both are face-down mounted on each other while placing the protruded electrodes 51 in between.

The semiconductor chip 20 is typically composed only of the in-chip circuit 30, and it is to be understood that the portions of the in-chip circuit 30 connected to the protruded electrodes 51 are portions of interconnections 81 composing the in-chip circuit 30 (for example, portions of the topmost layer of the multi-layered interconnection shown in the drawings), formed in a style of electrode pads, to thereby have an area sufficient for the connection.

On the other hand, the semiconductor chip 22 comprises the in-chip circuit 32, a plurality of external connection circuits 42 drawn out from the internal circuits, and the electrode pads connected to the individual external connection circuits 42. Of these, portions of interconnections 91 composing the in-chip circuit 32 (for example, portions of the topmost layer of the multi-layered interconnection shown in the drawings) are formed in a style of electrode pads, where the semiconductor chip 20 is connected while placing the protruded electrodes 51 in between. The electrode pads 92 connected to the individual external connection circuits 42 are aimed at connection between the semiconductor device having these semiconductor chips 20, 22 mounted thereon and an external instrument, and are disposed on the outer circumferential side of the semiconductor chip 22.

As described in the above, the semiconductor device 1 of the fourth embodiment is configured so that the protruded electrodes 51 are held between portions of the interconnections 81, 91, composing the in-chip circuits 30, 32 of the individual semiconductor chips 20, 22 (for example, portions of the topmost layer of the multi-layered interconnection shown in the drawings) and formed in a style of electrode pads, and therefore makes it possible to directly connect the in-chip circuits 30, 32 of the semiconductor chips 20, 22 with each other, without being mediated by any external connection circuits including an I/O circuit.

A method of fabricating the semiconductor device 1 of the fourth embodiment is as follows. First, similarly to the first embodiment, the individual semiconductor chips, respectively having the internal circuits, the external connection circuits and the connection pads formed therein, are fabricated on the surface of a wafer as precursory forms of the semiconductor chips 20, 22 shown in Fig. 8, and the connection pads are touched with probes for functional inspection of the individual internal circuits of the individual semiconductor chips. Thereafter, the wafer is separated into the individual semiconductor chips 20, 22 shown in Fig. 8, and only those accepted by the functional inspection are picked up.

When the wafer is divided into the individual semiconductor chips 20, 22, necessary portions of the semiconductor chips formed on the surface of the wafer are left unremoved, and the other portions are removed by cutting. More specifically, from a semiconductor chip as a precursor of the semiconductor chip 20, the external connection circuit and the electrode pads are cut off, to thereby obtain the semiconductor chip 20 composed only of the in-chip circuit 30. From a semiconductor chip as a precursory form of the semiconductor chip 22, only the in-chip circuit 32, necessary portions of the external connection circuits 42, and the electrode pads 92 connected thereto are left unremoved, whereas the other portions are removed by cutting, to thereby obtain the semiconductor chip 22.

Another method capable of dispensing with the cutting is such as using chips in a form of the semiconductor chips 20, 22, preliminarily adopting a layout in which no electrode pads nor external connection circuits are provided along one edge of each chip to be connected to the internal connection circuits.

The protruded electrodes 51 are then formed on the portions, made in a style of electrode pads, of the interconnection composing the in-chip circuit 30 (or in-chip circuit 32), under provision of the protection circuits 406 on the signal lines. The protruded electrodes 51 are preferably formed on the wafer before being divided into the semiconductor chips 20, 22.

The semiconductor chip 20 and the semiconductor chip 22 are then disposed so as to oppose the surfaces having the in-chip circuits 30, 32 formed thereon, under provision of the protection circuits 406 on the signal lines, and the semiconductor chip 20 is mounted on the semiconductor chip 22 while placing the protruded electrodes 51 in between. The mounting herein is carried out so as to directly connect the in-chip circuits 30, 32 of the semiconductor chips 20, 22, while placing the protruded electrodes 51 in between. By the process, the semiconductor device 1 is completed.

Also by thus-configured semiconductor device 1 and the method of fabricating the same according to the fourth embodiment, it is made possible to obtain a semiconductor device allowing reduction in power consumption and increase in the operation speed, while using the semiconductor chips 20, 22 proven by the functional inspection to have a sufficient level of reliability, similarly to as described in the above-described first to third embodiments, because the in-chip circuits 30, 32 of the semiconductor chips 20, 22 are directly connected without being mediated by the external connection circuits including an I/O circuit.

The fourth embodiment can dispense with a so-called interposer because the semiconductor chip 20 (or semiconductor chip 22) is used as a support substrate, and can therefore realize a low-cost MCM saving any costs for the interposer.

In addition, the protection circuits 406 are provided on the signal lines having the protruded electrodes 51, an example of bumps, formed thereon, and the protection circuits 406 can absorb the plasma current, which is possibly generated during formation of the bumps (protruded electrodes 51 herein) on the surface of the chips, and possibly flows into the target signal lines on which the protruded electrodes 51 will be formed, so that it is made possible to prevent characteristics of the elements used for the in-chip circuits from being degraded or destructed by the plasma current.

Because the in-chip circuits 30, 32 of the semiconductor chips 20, 22 are connected in an electrically direct manner by mounting the semiconductor chip 20 on the semiconductor chip 22 while placing the protruded electrodes 51 in between, under provision of the protection circuits 406 on the signal lines, the protection circuits 406 can absorb the electric charge even if the electric charge accumulated on the semiconductor chips 20, 22 should flow into the target signal lines to be connected, and this makes it possible to prevent the characteristics of the elements used for the in-chip circuits from being degraded or destructed by the static electricity.

The protection circuits 406 will no more function as a load of the in-chip circuits 30, 32 during the normal operation, if the protection circuits 406 are disconnected from the signal lines after completion of the connection, or the face-down mounting. This makes it possible to prevent the in-chip circuits 30, 32 from being imposed with an unnecessary load, and to achieve a high-speed operation.

Although the fourth embodiment exemplified a configuration in which a single semiconductor chip 20 was opposed to a single semiconductor chip 22, the configuration is not limited thereto. For example, other allowable configurations include such as mounting a plurality of semiconductor chips 20 on the semiconductor chip 22 as a support substrate, or *vice versa,* in which the plurality of semiconductor chips mounted on a single semiconductor chip may have internal circuits different from or identical to each other in the functions thereof.

As has been described in the above, the semiconductor device of the present invention, based on the direct connection between the semiconductor chips at the in-chip circuit portions, makes it possible to prevent power consumption by the external connection circuits, and to prevent any operation delay between the semiconductor chips ascribable to any mediatory external connection circuits, and to achieve faster operation speed and lower power consumption of the MCM-type semiconductor devices.

It is also made possible to protect the circuit elements from electrostatic damage or from plasma damage, by providing the switching circuit between the signal lines, directly connecting the in-chip circuits, and the protection circuit, and by directly connecting the in-chip circuits or by forming the bumps while keeping the input and output of the switching circuit in connection during the device fabrication. After completion of the device fabrication, the protection circuits will no more function as a load of the in-chip circuits, if the input and output of the switching circuit is disconnected, and this makes it possible to achieve a high speed operation.

According to the method of fabricating a semiconductor device of the present invention, a step of forming the bumps at the target portions to be connected was provided, or the functional inspection of the internal circuits was carried out using a necessary and sufficient number of external connection circuits, under provision of the protection circuit on the signal lines which directly connect the in-chip circuits, and then a step of directly connecting the semiconductor chips between the internal circuit portions was provided, under provision of the protection circuit an the signal lines which directly connect the in-chip circuits. This makes it possible to obtain a semiconductor device allowing reduction in power consumption and increase in the operation speed, and at the same time allowing improvement in the reliability and yield rate of MCM, while using the semiconductor chips proven to have a sufficient level of reliability.

Even for the case where the semiconductor chips have no switching circuit capable of separating the protection circuit from the signal lines, it is made possible to electrically separate the protection circuit using laser blow or dry etching such as RIE, after completion of the device fabrication, so as to prevent the protection circuit from functioning as a load of the in-chip circuits, and thereby to achieve a high speed operation.

## Claims

1. A semiconductor device configured as having a plurality of semiconductor chips each composed of a semiconductor element and having at least an internal circuit formed therein, **characterized in that**:
signal lines connecting said internal circuits respectively formed in said plurality of semiconductor chips are connected in an electrically direct manner; and
a first protection circuit preventing said semiconductor elements from being damaged by the connection of said signal lines connecting said internal circuits with each other is provided.

2. The semiconductor device as claimed in Claim 1, **characterized in that**:
said first protection circuit is disposed, in at least one chip out of said plurality of semiconductor chips, on the signal line between a connection area connected to said internal circuit of the other and said internal circuit of its own.

3. The semiconductor device as claimed in Claim 2, **characterized in that**:
said first protection circuit is disposed, in every chip out of said plurality of semiconductor chips, on each signal line between a connection area connected to said internal circuit of the other and said internal circuit on the semiconductor chip.

4. The semiconductor device as claimed in Claim 1, **characterized in that**:
said semiconductor chip is provided with an external connection circuit formed therein, equipped with a second protection circuit which is electrically connected to said signal line so as to transmit signals on said signal line to an external instrument, and protecting said semiconductor element from being damaged by said connection; and
said first protection circuit is provided on the signal line connecting said internal circuits with each other, besides said second protection circuit.

5. The semiconductor device as claimed in Claim 1, **characterized in that**:
said semiconductor chip is provided with an external connection circuit formed therein, equipped with a second protection circuit which is electrically connected to said signal line so as to transmit signals on said signal line to an external instrument, and protecting said semiconductor element from being damaged by said connection; and
a protection performance of said protection circuit against said damage differs from a protection performance of said second protection circuit owned by said external connection circuit.

6. The semiconductor device as claimed in Claim 1, **characterized by** having a switching circuit capable of switching of electrical connection and disconnection, to or from said signal line, of at least a portion of circuit components composing said first protection circuit.

7. A method of fabricating a semiconductor device configured as having a plurality of semiconductor chips each composed of a semiconductor element and having at least an internal circuit formed therein, **characterized by** having:
a connecting step of connecting said individual internal circuits of said plurality of semiconductor chips in an electrically direct manner, each of said plurality of semiconductor chips comprising a protection circuit protecting a semiconductor element in said internal circuit from a damage due to the electrical and direct connection between one internal circuit and the internal circuit on the other semiconductor chip; while activating said protection circuit.

8. A method of fabricating a semiconductor device configured as having a plurality of semiconductor chips each composed of a semiconductor element and having at least an internal circuit formed therein, **characterized by** having:
an electrode forming step of forming protruded electrodes connecting the individual internal circuits of said plurality of semiconductor chips in an electrically direct manner, each of said plurality of semiconductor chips comprising a protection circuit protecting a semiconductor element in said internal circuit from a damage due to the electrical and direct connection between said internal circuit and the internal circuit on the other semiconductor chip; while keeping said protection circuit active.

9. The method of fabricating a semiconductor device as claimed in Claim 8, **characterized by** having a connecting step of connecting the individual internal circuits of said plurality of semiconductor chips in an electrically direct manner, using said protruded electrodes formed in said electrode formation step, while keeping said protection circuit active.

10. The method of fabricating a semiconductor device as claimed in Claim 7 or 9, **characterized by** having, preceding said connection step, an inspecting step of inspecting functions of said internal circuits of said plurality of semiconductor chips, for every semiconductor chip.

11. The method of fabricating a semiconductor device as claimed in Claim 10,
**characterized in that**:
said semiconductor chip is provided with an external connection circuit formed therein, electrically connected to a signal line derived from said internal circuit so as to transmit signals on said signal line to an external instrument; and **characterized by** further having:
between said inspection step and said connection step, an isolating step of electrically isolating at least a part of said external connection circuit provided corresponding to a target signal line directly connecting said internal circuits.

12. The method of fabricating a semiconductor device as claimed in Claim 10, **characterized in that** said inspecting step is carried out through said external connection circuit formed on said semiconductor chip.

13. The method of fabricating a semiconductor device as claimed in Claim 7, **characterized by** further having, following said connecting step, a separating step of electrically separating at least a part of circuit components composing said protection circuit from the signal line directly connecting said internal circuits.

## Amended claims

### Amended claims under Art. 19.1 PCT

1. (Canceled)

2. (Canceled)

3. (Canceled)

4. (Amended) A semiconductor device configured as having a plurality of semiconductor chips each composed of a semiconductor element and having at least an internal circuit formed therein, **characterized in that**:
signal lines connecting said internal circuits respectively formed in said plurality of semiconductor chips are connected in an electrically direct manner,
a first protection circuit preventing said semiconductor elements from being damaged by the connection of said signal lines connecting said internal circuits with each other is provided, and
said semiconductor chip is provided with an external connection circuit formed therein, equipped with a second protection circuit which is electrically connected to said signal line so as to transmit signals on said signal line to an external instrument, and protecting said semiconductor element from being damaged by said connection.

5. (Amended) The semiconductor device as claimed in Claim 4, **characterized in that**:
a protection performance of said first protection circuit against said damage differs from a protection performance of said second protection circuit owned by said external connection circuit.

6. (Amended) The semiconductor device as claimed in Claim 4, **characterized in that** a part of circuit components composing said first protection circuit has a switching circuit capable of switching of electrical connection and disconnection to or from said signal line.

7. (Amended) A method of fabricating a semiconductor device configured as having a plurality of semiconductor chips each composed of a semiconductor element and having at least an internal circuit formed therein, **characterized by** having:
a connecting step of connecting said individual internal circuits of said plurality of semiconductor chips in an electrically direct manner, each of said plurality of semiconductor chips provided with a protection circuit for protecting said semiconductor element in said internal circuit from a damage due to the electrical and direct connection between said internal circuits respectively formed on said plurality of semiconductor chips; while activating said protection circuit.

8. (Amended) A method of fabricating a semiconductor device configured as having a plurality of semiconductor chips each composed of a semiconductor element and having at least an internal circuit formed therein, **characterized by** having:
an electrode forming step of forming protruded electrodes connecting the individual internal circuits of said plurality of semiconductor chips in an electrically direct manner, each of said plurality of semiconductor chips comprising a first protection circuit protecting said semiconductor element from a damage caused by connecting electrically and directly between said internal circuits respectively formed on said plurality of semiconductor chips other semiconductor chip, while keeping said protection circuit active.

9. (Amended) The method of fabricating a semiconductor device as claimed in Claim 8, **characterized by** having a connecting step of connecting the individual internal circuits of said plurality of semiconductor chips in an electrically direct manner, using said protruded electrodes formed in said electrode formation step, while keeping said first protection circuit active.

10. (Amended) The method of fabricating a semiconductor device as claimed in Claim 7 or 9, **characterized by** having, preceding said connection step, an inspecting step of inspecting functions of said internal circuits of said plurality of semiconductor chips, for every semiconductor chip.

11. (Amended) The method of fabricating a semiconductor device as claimed in Claim 10, **characterized in that**:
said semiconductor chip is provided with an external connection circuit formed therein, electrically connected to a signal line derived from said internal circuit so as to transmit signals on said signal line to an external instrument; and **characterized by** further having:
between said inspection step and said connection step, an isolating step of electrically isolating at least a part of said external connection circuit provided corresponding to a target signal line directly connecting said internal circuits.

12. The method of fabricating a semiconductor device as claimed in Claim 10, **characterized in that** said inspecting step is carried out through said external connection circuit formed on said semiconductor chip.

13. (Canceled)
